# EUROPÄISCHE PATENTSCHRIFT

(11) **EP 2 771 917 B1**
(45) Veröffentlichungstag und Bekanntmachung des Hinweises auf die Patenterteilung: **08.07.2015**
(21) Anmeldenummer: 12784511.3
(22) Anmeldetag: 22.10.2012
(51) Int. Cl.: H01L 35/34, H01L 35/32

(54) **THERMOELEMENT, HERSTELLUNGSVERFAHREN UND FÜR DIE DURCHFÜHRUNG DES VERFAHRENS GEEIGNETES SUBSTRAT**
THERMOCOUPLE, METHOD OF PRODUCTION AND SUBSTRATE THAT IS SUITABLE FOR CARRYING OUT THE METHOD
THERMOÉLÉMENT, SON PROCÉDÉ DE PRODUCTION ET SUBSTRAT SERVANT À LA MISE EN OEUVRE DE CE PROCÉDÉ

(30) Priorität: 24.10.2011 DE 102011054739
(43) Veröffentlichungstag der Anmeldung: 03.09.2014
(73) Patentinhaber: O-Flexx Technologies Gmbh, 47059 Duisburg (DE)
(72) Erfinder: HOPPE, Stefan, 46286 Dorsten (DE)
(74) Vertreter: Kohlmann, Kai
(86) Internationale Anmeldenummer: PCT/EP2012/070876
(87) Internationale Veröffentlichungsnummer: WO 2013/060648

(56) Entgegenhaltungen:
- EP-A2- 1 102 333
- GB-A- 911 828

## Beschreibung

Die Erfindung betrifft ein Verfahren zur Herstellung eines Thermoelements mit mindestens zwei Thermoschenkeln jeweils aus p- und n-dotiertem Halbleitermaterial, die abwechselnd an einer heißen und einer kalten Seite elektrisch leitend miteinander verbunden sind, ein nach dem Verfahren herstellbares Thermoelement sowie ein für das Verfahren bereitgestelltes Substrat.

Die Wirkungsweise von Thermoelementen beruht auf dem thermoelektrischen Effekt. Beim Seebeck-Effekt entsteht zwischen zwei Punkten eines elektrischen Leiters bzw. Halbleiters, die eine verschiedene Temperatur haben, eine elektrische Spannung. Während der Seebeck-Effekt das Entstehen einer Spannung beschreibt, tritt der Peltier-Effekt ausschließlich durch das Fließen eines äußeren Stromes auf. Der Peltier-Effekt tritt auf, wenn zwei Leiter oder Halbleiter mit unterschiedlichen elektronischen Wärmekapazitäten in Kontakt gebracht werden und durch einen von außen angelegten elektrischen Strom Elektronen aus dem einen Leiter / Halbleiter in den anderen fließen. In einem stromdurchflossenen Thermopaar treten immer beide thermoelektrischen Effekte auf.

Thermoelemente bestehen vorzugsweise aus unterschiedlich dotierten Halbleitermaterialien, wodurch sich die Effizienz gegenüber Thermoelementen mit zwei unterschiedlichen und an einem Ende miteinander verbundenen Metallen, wesentlich steigern lässt. Gebräuchliche Halbleitermaterialien sind Bi2Te3, PbTe, SiGe, BiSb oder FeSi2.

Ein herkömmliches Thermoelement besteht aus zwei oder mehreren kleinen Quadern aus p- und n-dotiertem Halbleitermaterial, die abwechselnd oben und unten durch Metallbrücken miteinander verbunden sind. Die Metallbrücken bilden zugleich die thermischen Kontaktflächen auf einer heißen bzw. kalten Seite des Thermoelementes und sind zumeist zwischen zwei im Abstand zueinander angeordneten Keramikplatten angeordnet. Jeweils ein n-dotierter und ein p-dotierter Quader bilden ein Thermopaar, wobei sich die Quader zwischen der heißen und der kalten Seite des thermoelektrischen Elementes erstrecken. Die unterschiedlich dotierten Quader sind durch die Metallbrücken so miteinander verbunden, dass sie eine Reihenschaltung ergeben.

Sofern den Quadern ein elektrischer Strom zugeführt wird, kühlen sich, abhängig von der Stromstärke und Stromrichtung, die Verbindungsstellen der Quader auf der kalten Seite ab, während sie sich auf der gegenüberliegenden heißen Seite erwärmen. Der angelegte Strom erzeugt damit eine Temperaturdifferenz zwischen den Keramikplatten. Wird indessen eine unterschiedlich hohe Temperatur an den gegenüberliegenden Keramikplatten angelegt, wird abhängig von der Temperaturdifferenz ein Stromfluss in den Quadern des Thermoelementes hervorgerufen.

Die Kantenlängen der Quader in sämtlichen Richtungen betragen etwa 1 - 3 mm. Die Form der Quader ist annähernd an einen Würfel angenähert. Die erhebliche Dicke der Quader ist erforderlich, da diese nicht nur zur Erzielung des thermoelektrischen Effektes dienen, sondern darüber hinaus für die mechanische Stabilität des thermoelektrischen Elementes sorgen. Die Quader benötigen viel Halbleitermaterial, das zur Erzielung des thermoelektrischen Effektes nicht erforderlich ist.

Die GB 911 828 A offenbart ein Thermoelement an dessen Quadern Metallplatten sowohl auf der kalten als auch der heißen Seite angelötet sind. Die auf der heißen und kalten Seite versetzt zueinander angeordneten Metallplatten sind jeweils entlang einer Linie um 90° abgekantet. Die abgekanteten Bereiche der Metallplatten auf der heißen und kalten Seite sind parallel und im Abstand zueinander angeordnet. Zwischen den abgekanteten Bereichen gegenüberliegender Metallplatten werden die Quader verlötet. Anschließend werden die Quader und Teile der Platten in einer elektrisch isolierenden und thermisch schlecht leitenden Masse vergossen. Durch den Verguss soll die Stabilität des Thermoelements verbessert werden. Ein Nachteil des bekannten Thermoelementes besteht darin, dass die Quader für die Platzierung und Verlötung zwischen den abgekanteten Bereichen relativ groß sein müssen. Die Platzierung und Verlötung zwischen den abgekanteten Bereichen steht auch einer massenhaften und preiswerten Herstellung der Thermoelemente entgegen.

Neben den herkömmlichen Thermoelementen sind so genannte Dünnschicht-Thermoelemente bekannt. Aus der DE 101 22 679 A1 ist beispielsweise ein Dünnschicht-Thermoelement bekannt, das ein flexibles Substratmaterial aus Kunststoff aufweist, auf dem Dünnschicht-Thermopaare aufgebracht sind. Es werden nebeneinander angeordnete, streifenförmige Thermoschenkel aus einem ersten Material und aus einem zweiten Material gebildet, wobei die Thermoschenkel an ihren Enden jeweils paarweise über eine Kopplungsstruktur, insbesondere aus dem zweiten Material elektrisch leitend miteinander verbunden sind. Das Aufbringen der Thermoschenkel und Kopplungsstrukturen erfolgt mittels üblicher Abscheidungsverfahren. Durch die abwechselnd an der heißen und an der kalten Seite gekoppelten Thermoschenkel wird eine Serienschaltung von mehreren Thermopaaren auf einer kleinen Fläche von etwa 8 x 15 mm gebildet. Die Dicke der Thermoschenkel eines Dünnschicht-Thermoelementes liegt in einem Bereich von 1-10µm.

Die Dünnschichttechnik hat den Nachteil, dass der elektrische Widerstand des Thermoschenkels aufgrund der geringen Schichtdicke sehr groß ist, was sich nachteilig auf den Wirkungsrad auswirkt. Um die instabilen Thermoschenkel zu stabilisieren, müssen diese zwingend vollflächig auf dem Kunststoffsubstrat aufgebracht werden. Die geringe Wärmeleitfähigkeit des Kunststoffsubstrats wirkt sich zwar grundsätzlich positiv auf den Wirkungsgrad des Dünnschicht-Thermoelementes aus, problematisch ist jedoch die Ein- und Auskopplung der Wärme in die Kopplungsstrukturen des Thermoelementes an der heißen und kalten Seite, die auf dem Substrat aus Kunststoff aufgebracht sind. Schließlich ist das Aufbringen der Thermoschenkel auf das Kunststoffsubstrat und damit die Herstellung des Thermoelementes aufwändig.

Die EP 1 976 034 A offenbart ein weiteres Dünnschicht-Thermoelement, dessen Thermoschenkel auf einem Substrat mit teilweise isolierenden Eigenschaften angeordnet sind, das sich zwischen zwei Rahmenteilen an der heißen und kalten Seite des Thermoelementes erstreckt.

Ausgehend von diesem Stand der Technik liegt der Erfindung die Aufgabe zu Grunde, ein Verfahren zur preiswerten Herstellung von insbesondere flächigen Thermoelementen mit einer den herkömmlichen Thermoelementen vergleichbaren Stabilität bei gleichzeitig reduziertem Einsatz an thermoelektrischem Material vorzuschlagen.

Des weiteren soll ein für die Durchführung des Verfahrens geeignetes Substrat und ein nach dem Verfahren herstellbares flächiges Thermoelement mit hoher Stabilität angegeben werden.

Diese Aufgabe wird bei einem Verfahren der eingangs erwähnten Art dadurch gelöst, dass dieses die folgenden Schritte umfasst:
- Bereitstellen eines Substrats, das ausschließlich aus einem elektrisch und thermisch leitfähigen Material besteht und mindestens eine Durchbrechung aufweist, die das Substrat in Substratbereiche auf der heißen und Substratbereiche auf der kalten Seite des Thermoelementes unterteilt,
- Bestücken des Substrats mit Thermoschenkeln, wobei jeder Thermoschenkel auf einem Substratbereich auf der heißen Seite und einem Substratbereich auf der kalten Seite platziert und elektrisch und thermisch leitend mit dem Substratbereich auf der heißen Seite und dem Substratbereich auf der kalten Seite verbunden wird,
- Anbringen einer Kapselung, so dass zumindest jeder Thermoschenkel eingeschlossen wird und die Kapselung sich stoffschlüssig mit dem Substratbereich auf der heißen Seite und dem Substratbereich auf der kalten Seite jedes Thermoschenkels verbindet,
- Abtrennen von Teilen des Substrats derart, dass durch die mindestens eine Durchbrechung in dem Substrat ein elektrischer Stromfluss zwischen den Substratbereichen verhindert wird.

Auf dem bereitgestellten, vorzugsweise ebenen Substrat bestimmt die Durchbrechung die Lage der Substratbereiche auf der heißen und kalten Seite zueinander. Nach dem Bestücken und vorzugsweise nach dem Kapseln werden lediglich zur Stabilisierung vorgesehene Substratteile, insbesondere rahmenförmig die Substratbereiche umgebende Substratteile, abgetrennt. Nach dem Abtrennen der stabilisierenden und die Substratbereiche elektrisch leitend verbindenden Substratteile wird durch die mindestens eine Durchbrechung ein direkter elektrischer Stromfluss zwischen sämtlichen Substratbereichen auf der heißen und kalten Seite verhindert. Die Fixierung der Lage der Substratbereiche zueinander übernehmen nun die Thermoschenkel, die zuvor die Durchbrechung überbrückend mit einem Substratbereich auf der heißen Seite und einem Substratbereich auf der kalten Seite verbunden wurden sowie die vorzugsweise vor dem Abtrennen der Substratteile angebrachte Kapselung. Der gewollte Stromfluss zwischen den Substratbereichen über die die Durchbrechung überbrückenden Thermoschenkel ist jedoch uneingeschränkt möglich und wird durch das Abtrennen der Substratteile nicht beeinträchtigt. Zugleich werden die Substratbereiche auf der heißen und kalten Seite durch das Abtrennen der Substratteile thermisch entkoppelt.

Erfindungsgemäß erfolgt das Bestücken des Substrats mit Thermoschenkeln, die eine Dicke im Bereich von 20 µm - 500 µm aufweisen. Dieser Dickenbereich liegt oberhalb des Dickenbereichs der eingangs beschriebenen Dünnschichttechnik, jedoch deutlich unterhalb der geringsten Kantenlänge der Quader herkömmlicher thermoelektrischer Elemente. In diesem erfindungsgemäß genutzten Größen-Zwischenbereich lässt sich das Thermoelement, vergleichbar der Dünnschichttechnik, in einer Ebene aufbauen. Es ist möglich, elektrischen Strom und Wärme über die ebenen, elektrisch und thermisch leitfähigen Substratbereiche in die darauf aufliegenden Bereiche der flächigen Thermoschenkel zu leiten. Aufgrund der nun deutlich größeren Querschnitte der Thermoschenkel ggü. den in Dünnschichttechnik ausgeführten Thermoschenkeln lässt sich eine Kapselung zur Stabilisierung anbringen, ohne dass die thermische Effizienz stark beeinträchtigt wird. Eine vollflächige Stützung der Thermoschenkel durch ein elektrisch und thermisch schlecht leitendes Kunststoffsubstrat ist nicht mehr erforderlich; vielmehr können die Thermoschenkel unmittelbar auf die elektrisch und thermisch leitfähigen, durch die Durchbrechung beabstandeten Substratbereiche aufgebracht werden. Bei der bekannten Dünnschichttechnik ist bei der Nutzung des Wärmestroms in Richtung des als Schicht ausgebildeten Thermoschenkels der thermische Widerstand aufgrund der geringen Schichtdicke indes so groß, dass jede Art von technisch sinnvoller Kapselung einen thermischen Kurzschluss bewirken würde.

Wenn das bestückte Substrat nach dem Abtrennen von Teilen des Substrats in ungekapselten Substratbereichen um eine Biegelinie gebogen wird, lassen sich Kontaktabschnitte in einem Winkel von etwa 90 Grad abkanten, um eine stabile Anbindung der Substratbereiche an der heißen Seite an eine Wärmequelle und der Substratbereiche an der kalten Seite an eine Wärmesenke zu ermöglichen.

Um mit dem erfindungsgemäßen Verfahren Thermoelemente mit der bekannten mäanderförmigen Struktur aus Thermoschenkeln und Kopplungsstrukturen herzustellen, wird vorzugsweise ein Substrat mit den Merkmalen des Anspruchs 6 als Ausgangsmaterial bereitgestellt.

Ein insbesondere mit Hilfe des erfindungsgemäßen Verfahrens herstellbares Thermoelement weist die Merkmale des Anspruchs 7 auf:
Indem die Tragteile des Thermoelements ausschließlich aus einem elektrisch und thermisch gut leitfähigen Material bestehen, entfällt die Notwendigkeit, gesonderte Kopplungsstrukturen vorzusehen, um die Thermoschenkel elektrisch leitend an der heißen bzw. kalten Seite miteinander zu verbinden. Des Weiteren verbessert das thermisch gut leitfähige Material der Tragteile die Ein- und Auskopplung der Wärme in die Kopplungsstrukturen, die von den Tragteilen selbst gebildet werden. Als elektrisch und thermisch leitfähiges Material für die Tragteile kommen insbesondere Metalle zum Einsatz, die zudem eine hohe Wärmeleitfähigkeit aufweisen und hierdurch die Ein- und Auskopplung der Wärme in die Kopplungsstrukturen des Thermoelementes weiter verbessern.

Die ebenen Bestückungsoberflächen sämtlicher in einer Ebene liegender Tragteile lassen sich mit den flächigen Thermoschenkeln besonders einfach in automatisierten Herstellverfahren bestücken. Ein Randbereich jedes Thermoschenkels wird auf einem Tragteil auf der heißen Seite und das andere Ende auf einem Tragteil auf der kalte Seite platziert.

Die Tragteile sind derart im Abstand zueinander angeordnet, dass sie untereinander nicht in Kontakt gelangen. Hierdurch wird ein Kurzschluss zwischen den auch als Kopplungsstrukturen dienenden elektrisch leitfähigen Tragteilen verhindert. Außerdem bewirkt der Abstand zwischen den Tragteilen, dass die Tragteile auf der heißen Seite von den Tragteilen auf der kalten Seite thermisch entkoppelt sind. Der Abstand kann beispielsweise als Luftspalt mit einer Breite von etwa 0,1 mm ausgeführt sein.

Um den Verbund aus den Tragteilen und den relativ dünnen Thermoschenkeln, deren Dicke vorzugsweise in einem Bereich von 20 µm - 500 µm liegt, mechanisch weiter zu stabilisieren, weist das Thermoelement mindestens eine Kapselung auf, die stoffschlüssig mit dem Tragteil auf der heißen Seite und dem Tragteil auf der kalten Seite jedes Thermoschenkels verbunden ist und die jeden Thermoschenkel einschließt. Die Kapselung bewirkt eine Fixierung der Bauteile untereinander und erhöht zudem die Vibrations- und Stoßfestigkeit des Thermoelementes, was insbesondere bei Anbringung des Thermoelementes an (bewegten) Maschinen von Bedeutung ist. Die Kapselung stellt zudem einen Schutz vor Berührung, Feuchtigkeit und Verunreinigung für die empfindlichen Thermoschenkel dar. Die Kapselung wird insbesondere als Verguss ausgeführt. Die Kapselung besteht aus einem elektrisch nicht leitfähigen und auch thermisch relativ schlecht leitfähigen Material, wie beispielsweise Schaumkeramik, Glas oder Duroplasten. Aufgrund der Dicke der Thermoschenkel in dem angegeben bevorzugten Bereich beeinträchtigt die Kapselung bei geeigneter Materialwahl den Wirkungsgrad des Thermoelements kaum.

Sofern die Tragteile aus einem plastisch oder elastisch verformbaren Material bestehen, kann das Thermoelement in einer Vielzahl von möglichen Anwendungen eingesetzt werden. Des Weiteren erlaubt das verformbare Material in nicht gekapselten Bereichen, das Biegen der Tragteile.

Eine verbesserte Ein- und Auskopplung der Wärme in die als Kopplungsstrukturen dienenden Tragteile wird erreicht, wenn ein Kontaktabschnitt jedes Tragteils nicht von der Kapselung eingeschlossen ist. Über diesen Kontaktabschnitt kann die Wärme ungehindert durch die Kapselung ein- bzw. ausgekoppelt werden.

Um eine stabile Anbindung an eine Wärmequelle an der heißen bzw. Wärmesenke an der kalten Seite zu gewährleisten, können die Kontaktabschnitte aus der Ebene der Bestückungsoberfläche abgekantet sein.

Die abgekanteten Kontaktabschnitte lassen sich an zwei im Abstand und parallel zueinander angeordnete Platten eines Moduls befestigen, wobei die Kontaktabschnitte der Tragteile an der heißen Seite mit einer der beiden Platten und die Kontaktabschnitte der Tragteile an der kalten Seite mit der anderen der beiden Platten verbunden sind. Das derart zwischen den Platten des Moduls angeordnete Thermoelement kann ein- oder mehrfach um etwa 180 Grad um eine senkrecht zu den Platten verlaufende Biegelinie abgebogen werden (gefaltetes Thermoelement).

Nachfolgend wird das erfindungsgemäße Thermoelement sowie dessen Herstellung anhand der Figuren 1 - 8 näher erläutert. Es veranschaulichen:
- **Figur 1**: das Bereitstellen eines Substrats zur Herstellung eines Thermoelements,
- **Figur 2**: das Bestücken eines Substrats nach Figur 1 mit Thermoschenkeln,
- **Figur 3**: das Anbringen einer Kapselung,
- **Figur 4**: das Abtrennen von Substratteilen des Substrats nach Figur 1 und die Fertigstellung des Thermoelements,
- **Figur 5**: ein Thermoelement nach Figur 4 mit abgekanteten Kontaktabschnitten,
- **Figur 6**: ein Thermoelement nach Figur 5 mit wechselweise um 180 Grad um eine Biegelinie parallel zu den Stirnseiten des Substrats abgebogenen Abschnitten,
- **Figur 7**: ein Modul mit einem mehrfach gebogenen Thermoelement nach Figur 6 sowie
- **Figur 8**: ein vollständig ausgespritztes Modul nach Figur 7.

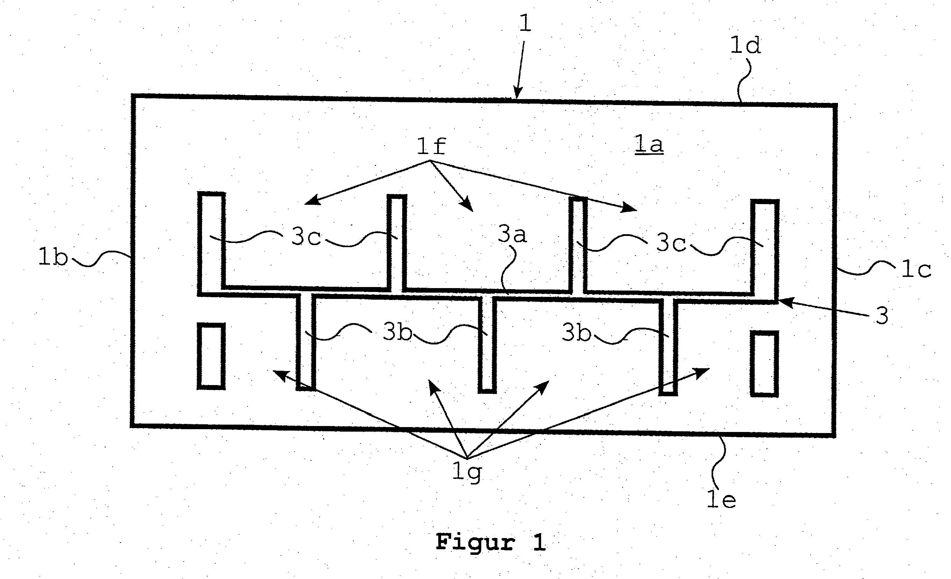

Figur 1 zeigt das Bereitstellen eines plattenförmigen Substrats (1) aus einem elektrisch leitfähigen Material, insbesondere in Form eines dünnen Blechs. Die Oberflächen (1a) des flächigen und quaderförmigen Substrats (1) sind seitlich durch Stirnseiten (1b, 1c), an der heißen Seite durch eine Längsseite (1d) und an der kalten Seite durch eine Längsseite (1e) begrenzt.

In dem Substrat (1) ist eine Durchbrechung (3) angeordnet, die das Substrat (1) in elektrisch leitfähige Substratbereiche (1f) auf der heißen und elektrisch leitfähige Substratbereiche (1g) auf der kalten Seite des Substrats unterteilt. Die Durchbrechung (3) weist einen ersten Abschnitt (3a) auf, der parallel zu den Längsseiten (1d, 1e) des Substrats (1) verläuft. Von dem ersten Abschnitt (3a) erstrecken sich jeweils drei zweite Abschnitte (3b) in Richtung der Längsseite (1e) auf der kalten Seite des Substrats. Von dem ersten Abschnitt (3a) erstrecken sich darüber hinaus vier dritte Abschnitte (3c) in Richtung der Längsseite (1d) auf der heißen Seite des Substrats, wobei die zweiten und dritten Abschnitte (3b, 3c) versetzt zueinander angeordnet sind. Ferner weist das Substrat (1) die Durchbrechung (3)und die Substratbereiche (1f, 1g) umgebende Substratteile auf, die einen Stabilisierungsrand bilden, der entlang der Längsseiten (1d, 1e) sowie der Stirnseiten (1b, 1c) des Substrats (1) verläuft.

Die Durchbrechung (3) ist im dargestellten Ausführungsbeispiel als Öffnung in dem Substrat zwischen den verschiedenen Substratbereichen (1f, 1g) ausgeführt. Das Substrat (1) ist im dargestellten Ausführungsbeispiel als Blech ausgeführt. Es kann sich jedoch auch um ein Substrat aus einem flexiblen, elektrisch leitfähigen Material handeln, das beispielsweise als Folie auf einer Spule aufrollbar ist.

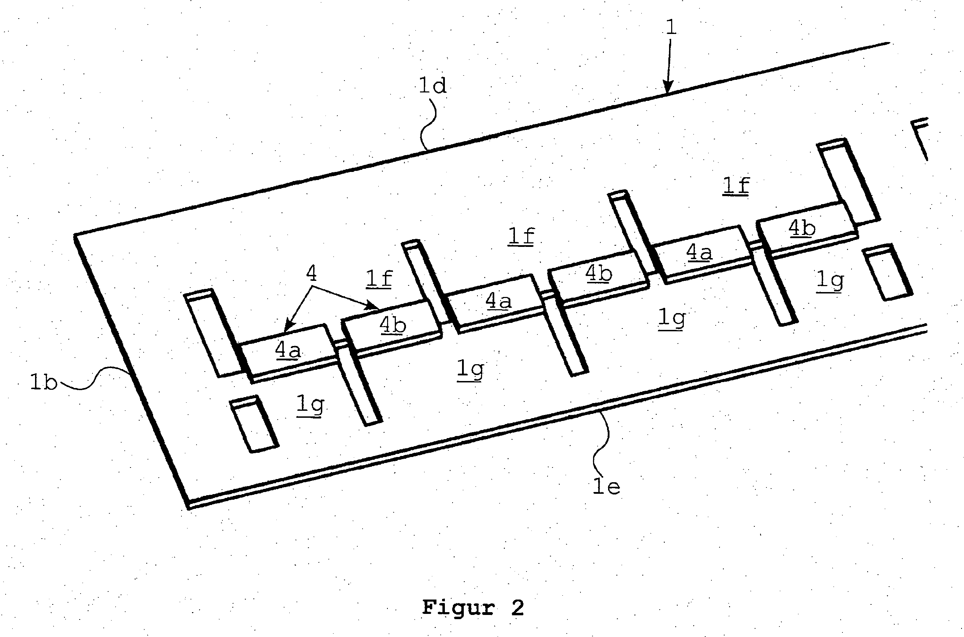

Figur 2 zeigt, wie das Substrat (1) nach Figur 1 mit Thermoschenkeln (4) bestückt wird. Die Thermoschenkel (4) aus p-dotiertem Halbleitermaterial (4a) und n-dotiertem Halbleitermaterial (4b) werden abwechselnd an der heißen Seite (1d) und der kalten Seite (1e) elektrisch leitend mittels der als Kopplungselemente dienenden Substratbereiche (1f, 1g) elektrisch leitend miteinander verbunden. Hierzu wird jeder Thermoschenkel (4) mit einem elektrisch leitfähigen Substratbereich (1f) auf der heißen und einem elektrisch leitfähigen Substratbereich (1g) auf der kalten Seite elektrisch leitend verbunden, wodurch die bekannte, mäanderförmige Struktur der Thermoschenkel (4a, 4b) aus p-und n-dotiertem Halbleitermaterial auf dem Substrat (1) entsteht. Die elektrisch leitende Verbindung wird mit Hilfe von Lot- oder Sinterpasten oder alternativ durch elektrisch leitfähige Klebstoffe hergestellt.

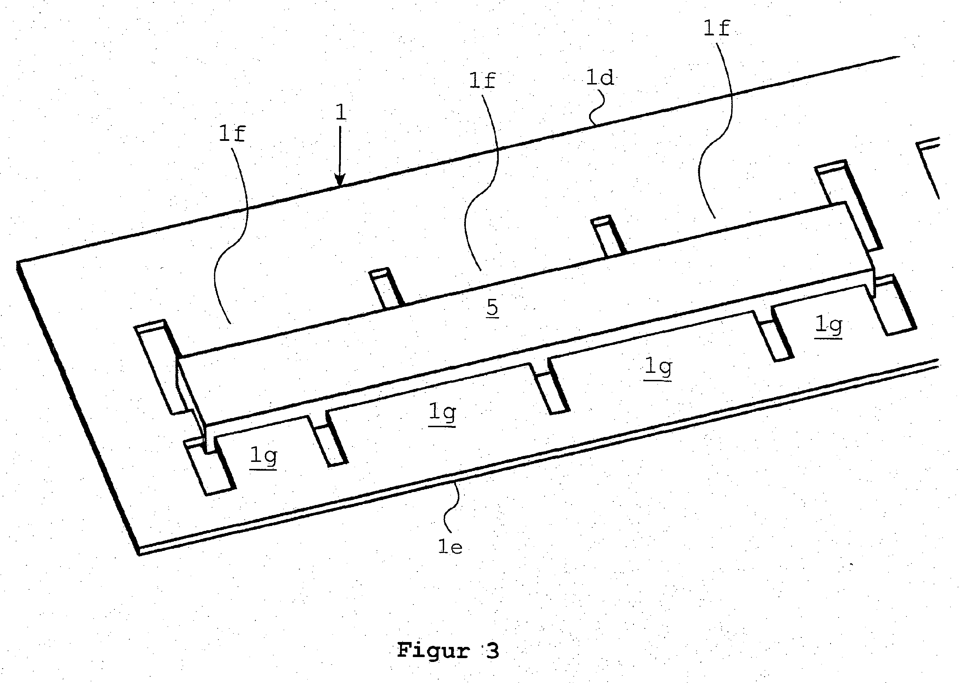

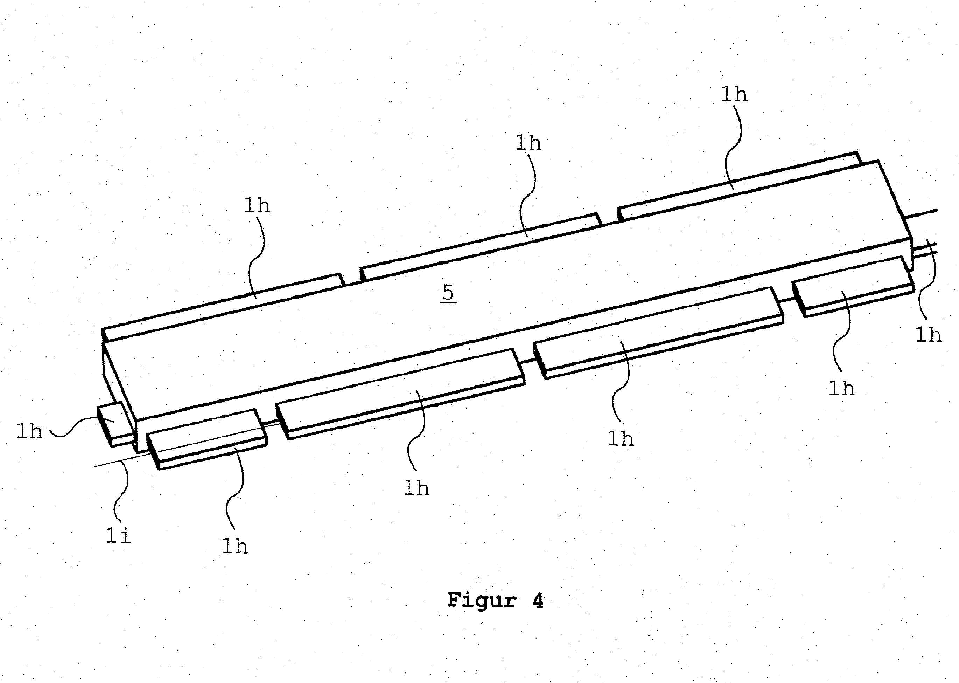

Anschließend wird eine in Figur 3 dargestellte Kapselung (5) auf dem Substrat (1) aufgebracht, die sich stoffschlüssig mit dem Substrat (1) in den Substratbereichen (1f) und (1g) verbindet und die Thermoschenkel (4a, 4b) vollständig einschließt. Die Kapselung (5) erstreckt sich über den ersten Abschnitt (3a) der Durchbrechung (3) hinweg, bis in die elektrisch leitenden Substratbereiche (1f, 1g) hinein, wobei jedoch mindestens ein in Figur 4 erkennbarer Kontaktabschnitt (1h) jedes elektrisch leitfähigen Substratbereichs (1f, 1g) nicht von der Kapselung (5) eingeschlossen wird.

Um einen Kurzschluss zwischen den elektrisch leitfähigen Substratbereichen (1f, 1g) zu vermeiden, besteht die Kapselung (5) aus einem elektrisch nicht leitfähigen anorganischen oder organischen Material. Die Kapselung kann im Wege des Spritzgießens, Vergießens oder durch Aufspritzen angebracht werden. Vorzugsweise wird das für die Kapselung (5) vorgesehene Material auf beiden Oberflächen (1a) des Substrats aufgebracht, so dass die Thermoschenkel (4) sowohl von der Ober- als auch der Unterseite vollständig eingeschlossen sind.

Um einen direkten elektrischen Stromfluss zwischen den elektrisch leitfähigen Substratbereichen (1f) auf der heißen und den Substratbereichen (1g) auf der kalten Seite zu verhindern, werden nach dem Bestücken (Figur 2) und Kapseln (Figur 3) die lediglich zur Stabilisierung dienenden Substratteile, der Stabilisierungsrand des Substrats '(1), abgetrennt. Das Abtrennen kann mittels eines Lasers oder eines anderen Schneid- und Stanzwerkzeugs in einem automatisierten Prozess erfolgen. Das nach dem Abtrennen des Stabilisierungsrandes fertiggestellte Thermoelement ist in Figur 4 dargestellt.

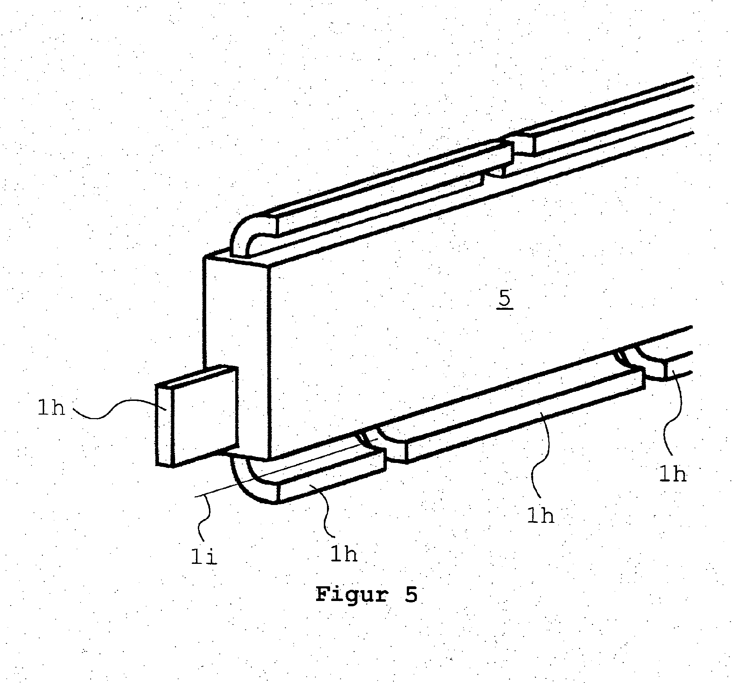

An den Kontaktabschnitten (1h) weist das Substrat Biegebereiche zum Biegen jedes Kontaktabschnitts (1h) um eine Biegelinie (1i) parallel zu den Längsseiten (1d, 1e) auf. Insbesondere bei relativ geringen Substratdicken kann es zweckmäßig sein, die Kontaktabschnitte (1h) etwa im Winkel von 90 Grad abzubiegen, wie dies in Figur 5 dargestellt ist, um eine stabile Verbindung zu im Abstand angeordneten keramischen Platten eines Moduls mit mindestens einem Thermoelement nach Figur 5 zu schaffen. Sofern das Abtrennen des Stabilisierungsrandes mit Hilfe eines Stanzwerkzeugs erfolgt, kann das Abbiegen um 90 Grad im selben Arbeitsschritt erfolgen.

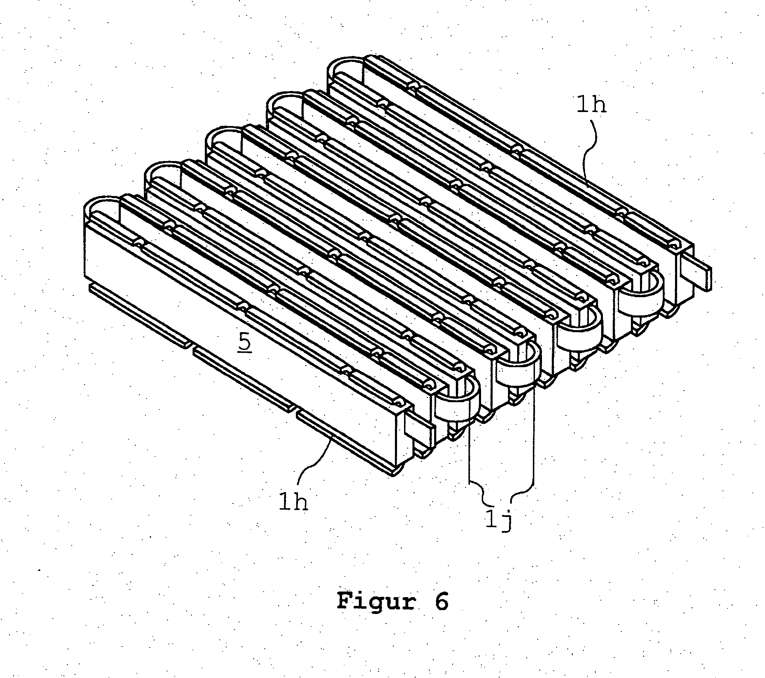

Ein lang gestrecktes Thermoelement kann jeweils zwischen zwei Thermoschenkeln (4a, 4b) mehrerer ungekapselter Biegebereiche zum Biegen des Substrats um eine Biegelinie (1j) parallel zu den Stirnseiten (1b, 1c) abwechselnd um 180 Grad im und gegen den Uhrzeigersinn gebogen werden. Hierdurch ergibt sich eine "gefaltete, dreidimensionale Struktur", wie sie in Figur 6 erkennbar ist.

Ein Thermoelement nach Figur 5 kann unmittelbar auf einer langgestreckten Wärmequelle bzw. Wärmesenke, beispielsweise einem Rohr, befestigt werden. Handelt es sich bei der Wärmequelle bzw. Wärmesenke um einen Gegenstand mit geringerer Längserstreckung, wird vorzugsweise eine gefaltete Struktur entsprechend Figur 6 mit dem Gegenstand verbunden. Möglichkeiten zur Verbindung sind beispielsweise Löten, Verschweißen oder Kleben.

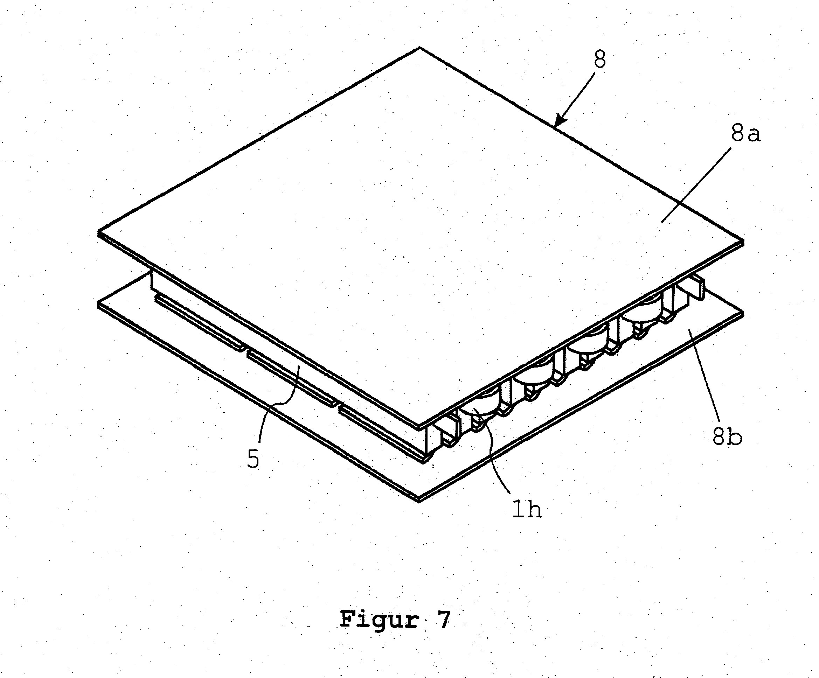

Eines oder mehrere der Thermoelemente entsprechend Figuren 4 oder 5 können auch zwischen zwei keramischen Platten angeordnet werden. Figur 7 zeigt ein gefaltetes Thermoelement entsprechend Figur 6, das zwischen zwei Platten (8a, 8b) angeordnet ist. Die Verbindung erfolgt in gleicher Weise, nämlich beispielsweise durch Löten, Verschweißen oder Kleben der Kontaktabschnitte (1h) mit den Platten (8a, 8b). Wichtig ist, dass die das Modul (8) bildenden Platten (8a, 8b) aus Materialien mit guter Wärmeleitfähigkeit bestehen, wobei durch die Platten keine elektrisch leitfähige Verbindung zwischen den verschiedenen Kontaktabschnitten (1h) hergestellt werden darf. In Betracht kommen insbesondere Keramik-Materialien.

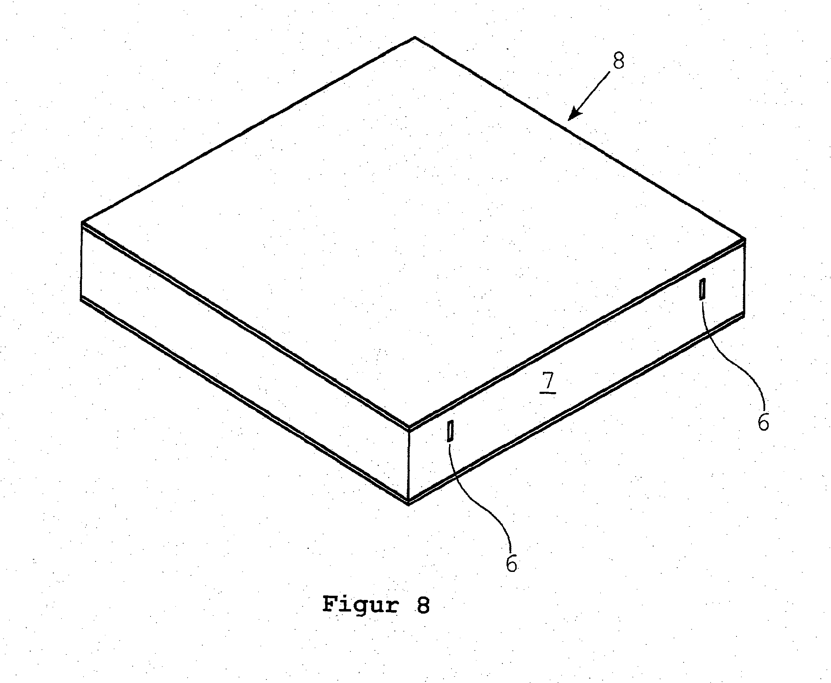

Schließlich kann das Modul nach Figur 7 zur weiteren Erhöhung der mechanischen Stabilität mit einer Füllmasse (7) aufgefüllt werden. Aus dem gefüllten, in Figur 8 dargestellten Modul (8) werden die elektrischen Kontakte (6) zur Kontaktierung des Thermoelementes herausgeführt.

Ein insbesondere nach dem erfindungsgemäßen Verfahren hergestelltes Thermoelement umfasst in Figur 2 erkennbare Thermoschenkel (4a, 4b) aus p- und n-dotiertem Halbleitermaterial, die abwechselnd an einer heißen Seite und einer kalten Seite elektrisch leitend miteinander verbunden sind, wobei ein Temperaturgradient zwischen der heißen und der kalten Seite des Thermoelementes an den in Figur 4 erkennbaren Kontaktabschnitten (1h) anlegbar oder abgreifbar ist.

Das Thermoelement weist mehrere durch die in Figur 4 dargestellte Kapselung (5) teilweise verdeckte ebene Tragteile auf der kalten und der heißen Seite des Thermoelementes (10) auf, die ausschließlich aus dem elektrisch und thermisch leitfähigen Material des zur Herstellung bereitgestellten und in Figur 1 dargestellten Substrats (1) bestehen. Lediglich die Kontaktabschnitte (1h) der Tragteile ragen aus der Kapselung (5) heraus, während die ebenen, sämtlich in einer Ebene liegenden Bestückungsflächen jedes Tragteils von der Kapselung (5) eingeschlossen sind.

Jeder Thermoschenkel (4a, 4b), ist auf einer Bestückungsfläche eines Tragteils auf der heißen Seite und einer Bestückungsfläche eines Tragteils auf der kalten Seite platziert und elektrisch und thermisch leitend mit der Bestückungsfläche auf der heißen Seite und der Bestückungsfläche auf der kalten Seite verbunden. Die Bestückungsfläche wird insbesondere aus den Substratbereichen (1f, 1g) des bereitgestellten Substrats (vgl. Figur 1) gebildet.

Die Tragteile sind sämtlich derart im Abstand zueinander angeordnet, dass sie untereinander nicht in Kontakt gelangen. Der Abstand entspricht insbesondere der Breite der Durchbrechung (3) in dem Substrat nach Figur 1.

Das Thermoelement weist vorzugsweise eine insbesondere in Figur 5 erkennbare Kapselung (5) auf, die beidseitig stoffschlüssig mit dem Tragteil auf der heißen Seite und dem Tragteil auf der kalten Seite jedes Thermoschenkels verbunden ist und die jeden Thermoschenkel einschließt. Hierdurch wird der Zugang zu den Thermoschenkeln von der Unterseite über die Abstandsflächen zwischen benachbarten Tragteilen ebenfalls gekapselt.

Die in Figur 2 erkennbaren Thermoschenkel (4a, 4b) weisen eine Dicke im Bereich von 20 µm - 500 µm auf. In diesem erfindungsgemäß genutzten Größen-Zwischenbereich lässt sich das Thermoelement, vergleichbar der Dünnschichttechnik, in einer Ebene aufbauen. Es ist möglich, elektrischen Strom und Wärme über die ebenen, elektrisch und thermisch leitfähigen Tragteile in die darauf aufliegenden Bereiche der flächigen Thermoschenkel zu leiten.

Die Tragteile bestehen aus einem plastisch verformbaren Material, insbesondere einem Metall. Dies erlaubt die Abkantung der Tragteile außerhalb des Bestückungsbereichs, um beispielsweise die in Figur 5 erkennbaren Kontaktabschnitte auszubilden.

**Bezugszeichenliste**

| **Nr.** | **Bezeichnung** | **Nr.** | **Bezeichnung** |
|---|---|---|---|
| 1 | Substrat | 7 | Füllmasse |
| 1a | Oberfläche | | |
| 1b | Stirnseiten | 8 | Modul |
| 1c | Stirnseiten | 8a | Platten (heiße Seite) |
| 1d | Längsseite | 8b | Platten (kalte Seite) |
| 1e | Längsseite | | |
| 1f | Substratbereiche | | |
| 1g | Substratbereiche | | |
| 1h | Kontaktabschnitt | | |
| 1i | Biegelinie | | |
| 1j | Biegelinie | | |
| | | | |
| | | | |
| | | | |
| 3 | Durchbrechungen | | |
| 3a | erster Abschnitt | | |
| 3b | zweite Abschnitte | | |
| 3c | dritte Abschnitte | | |
| | | | |
| | | | |
| | | | |
| 4 | Thermoschenkel | | |
| 4a | p-dotiertes Halbleitermaterial | | |
| 4b | n-dotiertes Halbleitermaterial | | |
| | | | |
| 5 | Kapselung | | |
| | | | |
| 6 | Elektrische Kontakte | | |

## Patentansprüche

1. Verfahren zur Herstellung eines Thermoelements mit mindestens zwei Thermoschenkeln (4) jeweils aus p- und n-dotiertem Halbleitermaterial, die abwechselnd an einer heißen und einer kalten Seite elektrisch leitend miteinander verbunden sind, umfassend die Schritte:
- Bereitstellen eines Substrats (1), das ausschließlich aus einem elektrisch und thermisch leitfähigen Material besteht und mindestens eine Durchbrechung (3) aufweist, die das Substrat (1) in Substratbereiche (1f) auf der heißen und Substratbereiche (1g) auf der kalten Seite des Thermoelements unterteilt,
- Bestücken des Substrats (1) mit Thermoschenkeln (4), wobei jeder Thermoschenkel (4) auf einem Substratbereich (1f) auf der heißen Seite und einem Substratbereich (1g) auf der kalten Seite platziert - und elektrisch und thermisch leitend mit dem Substratbereich (1f) auf der heißen Seite und dem Substratbereich (1g) auf der kalten Seite verbunden wird,
- Anbringen einer Kapselung (5), so dass zumindest jeder Thermoschenkel (4) eingeschlossen wird und die Kapselung (5) sich stoffschlüssig mit dem Substratbereich (1f) auf.der heißen Seite und dem Substratbereich (1g) auf der kalten Seite jedes Thermoschenkels (4) verbindet,
- Abtrennen von Teilen des Substrats derart, dass durch die mindestens eine Durchbrechung (3) in dem Substrat. (1) ein elektrischer Stromfluss zwischen den Substratbereichen (1f, 1g) verhindert wird.

2. Verfahren nach Anspruch 1, **dadurch gekennzeichnet, dass** das Substrat (1) mit Thermoschenkeln (4) mit einer Dicke im Bereich von 20 µm - 500 µm bestückt wird.

3. Verfahren nach Anspruch 1 oder 2, **dadurch gekennzeichnet, dass** das Abtrennen von Teilen des Substrats (1) nach.dem Anbringen der Kapselung (5) erfolgt.

4. Verfahren nach einem der Ansprüche 1 - 3, **dadurch gekennzeichnet, dass** das bestückte Substrat (1) nach dem Abtrennen von Teilen des Substrats in ungekapselten Substratbereichen um eine Biegelinie (1i) gebogen wird.

5. Verfahren nach einem der Ansprüche 1 bis 4, **dadurch gekennzeichnet, dass** zwei Platten (8a, 8b) aus einem Isolierstoff im Abstand und parallel zueinander angeordnet werden und das Substrat (1) an der heißen Seite mit einer der beiden Platten (8a) und an der kalten Seite mit der anderen der beiden Platten (8b) verbunden wird.

6. Substrat zur Bereitstellung in einem Verfahren nach einem der Ansprüche 1 bis 5, **dadurch gekennzeichnet, dass**
- das Substrat (1) ausschließlich aus einem elektrisch und thermisch leitfähigen Material besteht,
- das Substrat (1) quaderförmig ist,
- die Oberflächen (1a) des Substrats (1) seitlich durch Stirnseiten (1b, 1c) und an der heißen und kalten Seite durch Längsseiten (1d, 1e) begrenzt sind,
- das Substrat mindestens eine Durchbrechung (3) aufweist, die das Substrat (1) in Substratbereiche (1f) auf der heißen und Substratbereiche (1g) auf der kalten Seite des Thermoelementes unterteilt, wobei
- die Durchbrechung (3) in dem Substrat (1) einen ersten Abschnitt (3a) aufweist, der parallel zu den Längsseiten (1d, 1e) verläuft,
- die Durchbrechung (3) in dem Substrat (1) mindestens einen zweiten Abschnitt (3b) aufweist, der sich von dem ersten Abschnitt (3a) in Richtung der Längsseite (1e) auf der kalten Seite erstreckt,
- die Durchbrechung (3) in dem Substrat (1) mindestens einen dritten Abschnitt (3c) aufweist, der sich von dem ersten Abschnitt (3a) in Richtung der Längsseite (1d) auf der heißen Seite erstreckt und
- die zweiten und dritten Abschnitte (3b, 3c) versetzt zueinander angeordnet sind.

7. Thermoelement mit mindestens zwei Thermoschenkeln jeweils aus p- und n-dotiertem Halbleitermaterial, die abwechselnd an einer heißen und einer kalten Seite elektrisch leitend miteinander verbunden sind, wobei ein Temperaturgradient zwischen der heißen und der kalten Seite des Thermoelementes anlegbar oder abgreifbar ist, **dadurch gekennzeichnet, dass**
- das Thermoelement mehrere Tragteile auf der heißen und mehrere Tragteile auf der kalten Seite des Thermoelements aufweist, die ausschließlich aus einem elektrisch und thermisch leitfähigen Material bestehen,
- jedes Tragteil eine ebene Bestückungsoberfläche aufweist,
- die ebenen Bestückungsoberflächen sämtlicher Tragteile in einer Ebene liegen,
- die Tragteile derart im Abstand zueinander angeordnet sind, dass sie untereinander nicht in Kontakt gelangen,
- jeder Thermoschenkel mit der Bestückungsoberfläche eines Tragteils auf der heißen und der Bestückungsoberfläche eines Tragteils auf der kalten Seite elektrisch und thermisch leitend verbunden ist und
- das Thermoelement mindestens eine Kapselung aufweist, die stoffschlüssig mit dem Tragteil auf der heißen Seite und dem Tragteil auf der kalten Seite jedes Thermoschenkels verbunden ist und die jeden Thermoschenkel einschließt.

8. Thermoelement nach Anspruch 7, **dadurch gekennzeichnet, dass** die Thermoschenkeln eine Dicke im Bereich von 20 µm-500 µm aufweisen.

9. Thermoelement nach Anspruch 7 oder 8, **dadurch gekennzeichnet, dass** die Tragteile aus einem plastisch oder elastisch verformbaren Material bestehen.

10. Thermoelement nach einem der Ansprüche 7 bis 9, **dadurch gekennzeichnet, dass** ein Kontaktabschnitt (1h) der Tragteile nicht von der Kapselung (5) eingeschlossen ist.

11. Thermoelement nach Anspruch 10, **dadurch gekennzeichnet, dass** der Kontaktabschnitt (1h) aus der Ebene der Bestückungsoberfläche abgekantet ist.

12. Modul umfassend mindestens ein Thermoelement nach einem oder mehreren der Ansprüche 7 bis 11, **dadurch gekennzeichnet, dass** das Modul (8) zwei im Abstand und parallel zueinander angeordnete Platten (8a, 8b) aus einem Isolierstoff aufweist, wobei das Thermoelement an der heißen Seite mit einer der beiden Platten (8a) und an der kalten Seite mit der anderen der beiden Platten (8b) verbunden ist.

## Claims

1. A method for producing a thermocouple having at least two thermolegs (4), each made of p- and n-doped semiconductor material, which are electrically conductively interconnected alternately on a hot and a cold side, comprising the steps:
- providing a substrate (1) which consists exclusively of an electrically and thermally conductive material and has at least one aperture (3) which divides the substrate (1) into substrate regions (1f) on the hot side and substrate regions (1g) on the cold side of the thermocouple,
- fitting the substrate (1) with thermolegs (4), wherein each thermoleg (4) is placed on a substrate region (1f) on the hot side and on a substrate region (1g) on the cold side and is electrically and thermally conductively connected to the substrate region (1f) on the hot side and to the substrate region (1g) on the cold side,
- applying an encapsulation (5) so that at least each thermoleg (4) is enclosed and the encapsulation (5) bonds integrally to the substrate region (1f) on the hot side and to the substrate region (1g) on the cold side of each thermoleg (4),
- separating parts of the substrate in such a manner that a flow of electric current between the substrate regions (1f, 1g) is prevented by the at least one aperture (3) in the substrate (1).

2. The method according to claim 1, characterized the substrate (1) is fitted with thermolegs (4) having a thickness in the range of 20 µm - 500 µm.

3. The method according to claim 1 or 2, **characterized in that** the separation of parts of the substrate (1) is performed after the encapsulation (5) has been attached.

4. The method according to any one of claims 1-3, **characterized in that** after separating parts of the substrate, the fitted substrate (1) is bent in unencapsulated substrate regions around a bending line (1i).

5. The method according to any one of claims 1 to 4, **characterized in that** two plates (8a, 8b) made of an insulating material are arranged at a distance from one another and parallel to one another, and the substrate (1) on the hot side is connected to one of the two plates (8a) and on the cold side to the other of the two plates (8b).

6. A substrate for provision in a method according to any one of claims 1 to 5, **characterized in that**
- the substrate (1) consists exclusively of an electrically and thermally conductive material,
- the substrate (1) is cuboidal,
- the surfaces (1a) of the substrate (1) are delimited laterally by end sides (1b, 1c) and on the hot and cold side by longitudinal sides (1d, 1e),
- the substrate has at least one aperture (3) which divides the substrate (1) into substrate regions (1f) on the hot side and substrate regions (1g) on the cold side of the thermocouple, wherein
- the aperture (3) in the substrate (1) has a first portion (3a) which runs parallel to the longitudinal sides (1d, 1e),
- the aperture (3) in the substrate (1) has at least one second portion (3b) which extends from the first portion (3a) in the direction of the longitudinal side (1e) on the cold side,
- the aperture (3) in the substrate (1) has at least one third portion (3c) which extends from the first portion (3a) in the direction of the longitudinal side (1d) on the hot side and
- the second and third portions (3b, 3c) are arranged offset in relation to one another.

7. A thermocouple, comprising at least two thermolegs each made of p-doped and n-doped semiconductor material which are electrically conductively interconnected alternately on a hot and a cold side, wherein a temperature gradient between the hot and the cold side of the thermocouple can be applied or tapped, **characterized in that**
- the thermocouple has a plurality of supporting parts on the hot side and a plurality of supporting parts on the cold side of the thermocouple, which each consist exclusively of an electrically and thermally conductive material,
- each supporting part has a planar fitting surface,
- the planar fitting surfaces of all the supporting parts lie in one plane,
- the supporting parts are arranged at a distance from one another in such a manner that they do not contact one another,
- each thermoleg is electrically and thermally conductively connected to the fitting surface of a supporting part on the hot side and to the fitting surface of a supporting part on the cold side
- the thermocouple has at least one encapsulation which is bonded to the supporting part on the hot side and to the supporting part on the cold side of each thermoleg and which encloses each thermoleg.

8. The thermocouple according to claim 7, **characterized in that** the thermolegs have a thickness in the range of 20 µm - 500 µm.

9. The thermocouple according to claim 7 or 8, **characterized in that** the supporting parts consist of a plastically or elastically deformable material.

10. The thermocouple according to any one of claims 7 to 9, **characterized in that** a contact portion (1h) of the supporting parts is not encased by the encapsulation (5).

11. The thermocouple according to claim 10, **characterized in that** the contact portion (1h) is bent from the plane of the fitting surface.

12. A module comprising at least one thermocouple according to any one or several of claims 7 to 11, **characterized in that** the module (8) comprises two plates (8a, 8b) arranged at a distance from one another and parallel to one another and made of an insulating material, wherein the thermocouple is connected on the hot side to one of the two plates (8a) and is connected on the cold side to the other of the two plates (8b).

## Revendications

1. Procédé destiné à la production d'un thermocouple avec au moins deux branches thermoélectriques (4), chacune en matière semi-conductrice p-dopée et n-dopée, qui alternativement sur un côté chaud et sur un côté froid sont reliées ensemble de manière conductrice d'électricité, comprenant les étapes :
- la mise à disposition d'un substrat (1) qui est exclusivement constitué d'une matière conductrice électrique et conductrice thermique et qui comporte au moins un percement (3) qui divise le substrat (1) en zones de substrat (1f) sur le côté chaud et en zones de substrat (1g) sur le côté froid du thermocouple,
- l'équipement du substrat (1) avec des branches thermoélectriques (4), alors qu'on place chaque branche thermoélectrique (4) sur une zone de substrat (1f) sur le côté chaud et sur une zone de substrat (1g) sur le côté froid et on les relie de manière conductrice thermique et conductrice électrique avec la zone de substrat (1f) sur le côté chaud et la zone de substrat (1g) sur le côté froid,
- le montage d'un blindage (5), de sorte qu'au moins chaque branche thermoélectrique (4) soit enfermée et que le blindage (5) se relie par matière avec la zone de substrat (1f) sur le côté chaud et la zone de substrat (1g) sur le côté froid de chaque branche thermoélectrique (4),
- le sectionnement de parties du substrat de telle sorte qu'à travers l'au moins un percement (3) dans le substrat (1), un flux de courant électrique entre les zones de substrat (1f, 1g) soit empêché.

2. Procédé selon la revendication 1, **caractérisé en ce qu'**on équipe le substrat (1) de branches thermoélectriques (4) d'une épaisseur de l'ordre de 20 µm à 500 µm.

3. Procédé selon la revendication 1 ou la revendication 2, **caractérisé en ce que** le sectionnement de parties du substrat (1) s'effectue après le montage du blindage (5).

4. Procédé selon l'une quelconque des revendications 1 à 3, **caractérisé en ce qu'**après le sectionnement de parties du substrat en zones de substrat non blindées, on cintre le substrat (1) équipé autour d'une ligne de flexion (1i).

5. Procédé selon l'une quelconque des revendications 1 à 4, **caractérisé en ce qu'**on place avec un écart mutuel et à la parallèle l'une de l'autre deux plaques (8a, 8b) en une matière isolante et on relie le substrat (1) sur le côté chaud avec l'une des deux plaques (8a) et sur le côté froid avec l'autre des deux plaques (8b).

6. Substrat destiné à être mis à disposition lors d'un procédé selon la revendication 1 à 5, **caractérisé en ce que**
- le substrat (1) est constitué exclusivement en une matière conductrice électrique et conductrice thermique,
- le substrat est de forme parallélépipédique,
- les surfaces (1a) du substrat (1) sont délimitées latéralement par des faces frontales (1b, 1c) et sur le côté chaud et le côté froid par des côtés longitudinaux (1d, le),
- le substrat comporte au moins un percement (3) qui divise le substrat (1) en zones de substrat (1f) sur le côté chaud et en zones de substrat (1g) sur le côté froid du thermocouple,
- le percement (3) dans le substrat (1) comportant un premier segment (3a) qui s'étend à la parallèle des côtés longitudinaux (1d, le),
- le percement (3) dans le substrat (1) comportant au moins un deuxième segment (3b) qui s'étend du premier segment (3a) en direction du côté longitudinal (1e) sur le côté froid ;
- le percement (3) dans le substrat (1) comportant au moins un troisième segment (3c) qui s'étend du premier segment (3a) en direction du côté longitudinal (1d) sur le côté chaud et
- les deuxièmes et troisièmes segments (3b, 3c) étant placés en étant mutuellement décalés.

7. Thermocouple avec au moins deux branches thermoélectriques, chacune en une matière semi-conductrice p-dopée et n-dopée, qui alternativement sur un côté chaud et sur un côté froid sont reliées ensemble de manière conductrice d'électricité, un gradient thermique pouvant être appliqué ou prélevé entre le côté chaud et le côté froid du thermocouple, **caractérisé en ce que**
- le thermocouple comporte plusieurs parties porteuses sur le côté chaud et plusieurs parties porteuses sur le côté froid du thermocouple qui sont exclusivement constituées d'une matière conductrice électrique et conductrice thermique,
- chaque partie porteuse comporte une surface à équiper plane,
- les surfaces à équiper planes de toutes les parties porteuses se situent dans un plan,
- les parties porteuses sont placées avec un écart mutuel, de sorte à ne pas entrer en contact entre elles,
- chaque branche thermoélectrique est reliée de manière conductrice thermique et conductrice électrique avec la surface à équiper d'une partie porteuse sur le côté chaud et avec la surface à équiper d'une partie porteuse sur le côté froid et
- le thermocouple comporte au moins un blindage qui est relié par matière avec la partie porteuse sur le côté chaud et avec la partie porteuse sur le côté froid de chaque branche thermoélectrique et qui enferme chaque branche thermoélectrique.

8. Thermocouple selon la revendication 7, **caractérisé en ce que** les branches thermoélectriques présentent une épaisseur de l'ordre de 20 µm à 500 µm.

9. Thermocouple selon la revendication 7 ou la revendication 8, **caractérisé en ce que** les parties porteuses sont constituées d'une matière à déformation plastique ou élastique.

10. Thermocouple selon l'une quelconque des revendications 7 à 9, **caractérisé en ce qu'**un segment de contact (1h) des parties porteuses n'est pas enfermé dans le blindage (5).

11. Thermocouple selon la revendication 10, **caractérisé en ce que** le segment de contact (1h) est replié hors du plan de la surface à équiper.

12. Module comprenant au moins un thermocouple selon l'une quelconques ou plusieurs des revendications 7 à 11, **caractérisé en ce que** le module (8) comporte deux plaques (8a, 8b) placées avec un écart mutuel et à la parallèle l'une de l'autre en une matière isolante, le thermocouple étant reliée sur le côté chaud avec l'une des deux plaques (8a) et sur le côté froid avec l'autre des deux plaques (8b).
